# EUROPEAN PATENT APPLICATION

(11) **EP 4 287 236 A1**
(43) Date of publication of application: **06.12.2023**
(21) Application number: 22177146.2
(22) Date of filing: 03.06.2022
(51) Int. Cl.: H01J 37/20

(54) **DEVICE FOR HOLDING A SAMPLE, SYSTEM AND MANUFACTURING METHOD**

(71) Applicant: Forschungszentrum Jülich GmbH, 52425 Jülich (DE)
(72) Inventor: BASAK, Shibabrata, 52428 Jülich (DE); TAVABI, Amir Hossein, 52428 Jülich (DE); TEMPEL, Hermann, 52372 Kreuzau (DE); KUNGL, Hans, 69118 Heidelberg (DE); DUNIN-BORKOWSKI, Rafal Edward, 52428 Jülich (DE); EICHEL, Rüdiger-A., 52428 Jülich (DE)
(74) Representative: Gille Hrabal Partnerschaftsgesellschaft mbB Patentanwälte

(57) **Abstract**

The invention relates to a device for holding a sample for use with an optical appliance, a system, a method for manufacturing a device and a method for holding a sample in an optical appliance. A device (10) for holding a sample for use with an optical appliance, in particular an electron microscope, comprises a sample area (12) for arranging a sample, a light source (14) for illuminating the sample arranged in the sample area (12), a holding section (16) which enables the device (10) to be held by a sample holder of the optical appliance, and a contact section (18). The contact section (18) has at least two electrical contacts (20) for establishing an electrical connection with the sample holder to power the light source (14).

## Description

The invention relates to a device for holding a sample for use with an optical appliance, a system, a method for manufacturing a device and a method for holding a sample in an optical appliance.

In photoexcitation, matter absorbs photons to enter an excited state. This is the basis for numerous photoelectric processes such as for example photochemistry, photochromic applications, solar cells and luminescence processes. To investigate and improve such processes, it is required to determine relations between material characteristics of the matter, such as particle size, shape, structure, chemical state, and to relate the characteristics with device performance and/or efficiency. Microscopy may be used to study these characteristics. In particular, electron microscopy such as transmission electron microscopy is suitable to study the material characteristics in high resolution up to the atomic level.

Samples to be studied may be arranged by a sample holder (specimen holder) of an optical appliance. Recent developments have also led to nanoreactors which can be held by the sample holder. The nanoreactor comprises a sample area for arranging the sample to be studied. The nanoreactor in which the sample is arranged is then arranged inside the optical appliance and held by the sample holder. The nanoreactor may further have heating/cooling and/or biasing functionality. The above features may be combined with the aspects listed below, as well as with embodiments thereof.

In the field of photoexcitation, an optical fiber may be used to illuminate the sample with a light source arranged outside the nanoreactor. However, a specialized sample holder comprising the optical fiber and/or the light source is then required. The construction space required is large. Also, only a small part of the light can be utilized to illuminate the sample, so that the efficiency is low. Alternatively, specialized microscopes having a light source may be used. However, these specialized devices or components involve great technical effort.

A task of the invention is to provide a further developed device for holding a sample, a system, a method for manufacturing such a device and a method for holding a sample.

The task is solved by a device for holding a sample according to claim 1 and a system, a manufacturing method and a method for holding a sample as defined in the additional claims. Advantageous embodiments result from the dependent claims.

A device for holding a sample serves to solve the task. The device is suitable and/or configured for use with an optical appliance, in particular an electron microscope. In particular, the device is configured for holding a sample within the optical appliance. The device comprises a sample area for arranging a sample, in particular a sample to be studied, a light source for illuminating the sample arranged in the sample area, a holding section which enables the device to be held by a sample holder of the optical appliance, and a contact section. The contact section has at least two electrical contacts for establishing an electrical connection with the sample holder to power the light source.

The device according to the invention is in particular designed to visualize interaction of a sample with light using an optical appliance. The device is configured to contain a sample. The device is configured to be held by a sample holder having at least two electrical contacts. Thus, the device acts as a connector or adapter between the sample holder and the sample. The device can be used together with common sample holders of optical appliances such as electron microscopes having electrical contacts. The light source is part of the device. Thus, the light functionality can be used while, at the same time, using a common sample holder. Thus, it is not necessary to provide a specialized sample holder in order to visualize interaction of the sample with light using the optical appliance. The device enables to use any optical appliance for studying light-matter interaction. In-situ photoexcitation studies, i.e. photoexcitation studies performed under the optical appliance, can thus be performed easily and without great effort. Light-matter interaction can be visualized in operando, in particular in an electron microscope, without great effort.

In other words, the device comprises an interface which forms a mechanical and electrical interface to connect the device to a sample holder of the optical appliance. The interface comprises the holding section which enables the device to be held by the sample holder and the contact section having at least two electrical contacts for establishing an electrical connection to power the light source.

The holding section is configured such that the device can be held by the sample holder. For this purpose, a fixed mechanical connection may be established between the holding section and the sample holder. For example, the holding section may be clamped between two clamping means of the sample holder. Additionally or alternatively, the holding section may rest upon a surface of the sample holder. In one configuration, outer surfaces of the device are configured to be held or clamped by the sample holder.

The electrical contacts of the contact section are in particular made of metal, more particularly of a metal with good electrical conductivity and/or a material resistant against mechanical strain and/or high temperatures. For example, the electrical contacts may be configured as contact pads (bond pads). Contact pads are designated surface areas consisting of an electrically conductive material for establishing an electrical contact. For example, the sample holder may comprise needles for mechanically and electrically contacting the contact pads. Holding of the holding section may be performed by or using the mechanical connection of the needles and the contact pads. In other words, contact pads may provide the contact section and at least a part of the holding section at the same time.

The light source is in particular arranged to illuminate the sample while the sample is viewed by the optical appliance so that interaction of the sample with the light of the light source can be visualized. The light source relates to the device where the light is formed (produced), i.e., the place where the light is first emitted. A light source is thus configured to convert electrical energy into light. A light guide or deflecting member such as a mirror is not a light source in the sense of the invention. A light source in particular comprises two electrical contacts and a light emitting region. Light from a light source may be in the visible and/or non-visible part of the electromagnetic spectrum.

In one configuration, the light source has a luminous flux larger 0.05 lumens, preferably 0.1 lumens and/or smaller than 20 lumens, in particular 10 lumens. In one configuration, the light source is configured to be operated at a current larger than 0.5 mA, preferably 1 mA and/or smaller than 200 mA, preferably 100 mA. In one configuration, the light source is configured to be operated at a voltage larger than 0.5 V, preferably 1 V and/or smaller than 10 V, preferably 5 V. These ranges represent an optimum between good illumination and efficient operation.

In one configuration, the light source is covered by a translucent or transparent coating in order to separate the light source from the sample area. Thus, the sample and/or a fluid in the sample area does not contact or influence the light source. The coating may for example be made of silicon oxide or glass.

The sample area is configured to contain a sample. The sample may be solid, liquid and/or gaseous. In particular, the sample area is configured to hold the sample. In one configuration, a sample, which is in particular solid, can be fixed within the sample area and/or by the device.

The sample area is configured such that electrons can into the sample area and out of the sample area at least on one side of the sample area so that interaction of the sample with light can be observed by an electron microscope. For example, the device may comprise an opening through which electrons can reach the sample and back out. The sample area may be confined by one wall on each side, wherein two walls have overlapping openings so that transmission with electrons can be performed through the two walls.

The optical appliance may for example be a transmission electron microscope or a scanning electron microscope. For example, techniques such as bright-field, dark-field imaging, diffraction, electron energy loss spectroscopy (EELS), and energy dispersive X-ray (EDX) mapping may be performed. The optical appliance may be an imaging device. The optical appliance may be a spectroscopic device such as an X-ray photoelectron spectroscopic device for performing X-ray photoelectron spectroscopy (XPS) or an X-ray computed tomography device.

In particular, the device is a nanoreactor or a miniaturized cell. The behavior of materials during cell process can be visualized or studied using the device. Stimuli like creating a desired gas and/or liquid environment, heating, cooling and/or biasing may be used to perform a desired reaction.

In one configuration, the holding section comprises a form element for linear alignment of the device with respect to the sample holder. The form element may be referred to as linear aligner. The form element has in particular a linear extension and/or may be an edge. The linear aligner may be used for correct alignment and/or positioning of the device with respect to the sample holder in a linear direction. In particular, the holding section comprises a second linear aligner which may be similar to the linear aligner and arranged perpendicular to the linear aligner such that a desired position can easily be reached in both directions. In one configuration, the holding section comprises a form element for rotational aligning. The form element may be referred to as rotational aligner. The rotational aligner may be used for correct angular alignment and/or positioning of the device with respect to the sample holder. The form element has in particular a radial direction of extension.

In one embodiment, the device is a microelectromechanical system (MEMS). A microelectromechanical system in the sense of the invention is a microscopic device for studying and/or visualizing interaction of a sample with light in using a suitable optical appliance. A MEMS does not necessarily comprise moving parts. The device may also be a nanoelectromechanical system. In particular, the device is a MEMS-based wafer (chip) or comprises at least one MEMS-based wafer. In particular, the device has a maximum extension of less than 10 mm, in particular less than 5 mm and more particularly less or equal to 3 mm and/or more than 0.5 mm. In particular, the sample area has a sample volume for arranging the sample of less than 10⁹ pm³ and/or more than 10⁶ pm³.

In particular, the device comprises or is a transmission electron microscopy (TEM) and/or scanning electron microscopy (SEM)-compatible chip.

In one embodiment, the light source is a light-emitting diode (LED). In one embodiment, the device is manufactured at least partly from a wafer. In particular, the LED has been grown on the wafer. This means that at least one layer of the LED has been grown on the wafer. In particular, several or all layers of the LED have been grown successively one upon the other. In particular, at least a part of the device has been manufactured from a semiconductor such as silicon or GaAs.

In particular, the LED comprises an p-n junction comprising a p-type layer and an n-type layer. In particular, the LED comprises two electrical contacts, wherein a first electrical contact contacts the p-type layer and a second electrical contact contacts the n-type layer.

In particular, the LED is based on GaN or GaP. In particular, the LED has been grown on a wafer. The wafer may be a Si wafer or a GaAsP-based wafer. In case of a GaAsP-based wafer, the wafer may be wafer bonded to a Si wafer. There may be more than one GaAsP-based wafers which may be bonded to the Si wafer.

This enables to use a maximum area as light source and, thus, to illuminate the sample effectively and efficiently, especially in comparison to prior art using an optical fiber. The height of a grown LED is much smaller than the height of a common LED. Thus, the height of the device, in particular of the part of the device comprising the LED, can be very small. Thus, much space remains for the construction of other parts such as the sample area when absolute height limitations apply. In addition, it is not necessary to paste or bond and to connect a separate LED which would require more effort and is prone to errors.

In one embodiment, the device comprises an electron-transparent window to allow electrons to get into the device to the sample and/or get out of the device from the sample.

The electron-transparent window may be manufactured from silicon nitride (SiN, Si₃N₄).

Thus, a physical barrier exists between the sample area and the environment, in particular the vacuum environment inside the optical appliance. This allows to perform experiments in liquid and/or gas environments and/or at different or varying pressures, e.g. up to 1 bar or more. Thus, a great variety of photoelectrochemical reactions can be studied.

In one embodiment, the device comprises two separate parts, namely an upper part and a lower part. The light source is part of the upper part and the sample area is arranged on the lower part or is at least partly limited by the lower part. In particular, the contact section is part of the lower part.

In the assembled state, the upper part and the lower part lie against each other and/or together form the device. When disassembling the device, the upper part and the lower part are separated from each other. This embodiment allows for a particularly easy sample placement. The sample can be arranged on the lower part and the upper part is positioned above. The device is typically in the assembled state when held by the sample holder.

The sample can be secured against external influence as desired by suitable means such as an electron-transparent window. An electron-transparent window may be arranged in the upper part and/or in the lower part. If electron-transparent windows are provided in both the upper part and the lower part, the electron-transparent windows are in particular arranged on the same position, e.g. for transmission electron microscopy.

In one configuration, at least one dimension of the upper part is equal to the corresponding dimension of the lower part. In particular, the width of both parts may be the same.

In one configuration, the height of the sample area and/or the distance between the upper part and the lower part is more than 100 nm and/or less than 10 µm. Using a grown LED allows for a greater variability due to the space saved.

In one embodiment, the electrical contacts are arranged on the lower part. In particular, the upper part has two electrical contact points and the lower part has two electrical contact points and the contact points of the upper part electrically contact the contact points of the lower part in the assembled state of the device. Thus, an electrical connection is established in the assembled state for powering the light source arranged in the upper part by means of electricity provided by the sample holder.

In one embodiment, a sealing member is arranged between the upper part and the lower part to seal the sample area towards the environment.

This allows for easily opening and closing the sample area when the device has two parts and applying a gas and/or liquid environment and/or a different or varying pressure around the sample. For example, experiments under ambient atmosphere are possible. The atmosphere or environment relates to the gas and/or liquid content of the sample area. The composition and/or pressure of the atmosphere may be changed during an experiment and/or during illumination with light. For example, the effect of different gas and/or different pressure on photoexcitation activity can be visualized. In particular, the device can be used in a high-vacuum system. In particular, the device can be used to perform X-ray photoelectron spectroscopy (XPS).

In particular, an O-ring is used as a sealing member. A suitable groove may be provided in the upper part and/or in the lower part to ensure correct positioning of the sealing member and/or to ensure that the parts lie flat upon each other. In particular, the sealing member has a thickness above 0.1 pm, preferably 0.5 pm and/or below 200 pm, preferably 100 pm.

In one embodiment, the device comprises a fluid inlet which allows a fluid to enter the sample area and a fluid outlet which allows the fluid to be removed from the sample area.

A fluid is a gas, a liquid or a combination of both. This embodiment allows to easily introduce a fluid into the sample area and to remove it from the sample area, in particular in a continuous manner. Light-matter interaction can be easily visualized in different environments.

In one configuration, the device comprises an inlet tube in fluid connection with the fluid inlet so that fluid can be introduced into the sample area using the inlet tube. Alternatively, the inlet tube may be connected to the device using a suitable connector. In one configuration, the device comprises an outlet tube in fluid connection with the fluid outlet so that fluid can be removed from the sample area using the outlet tube. Alternatively, the outlet tube may be connected to the device using a suitable connector.

In one embodiment, the device comprises a heating means. In one embodiment, the device comprises a cooling means. In one embodiment, the device comprises a combined heating and cooling means. The contact section has at least two further electrical contacts for establishing an electrical connection with the sample holder to power the heating and/or cooling means.

The heating and/or cooling means is an electrical component which allows for heating and/or cooling the sample area and/or the sample arranged in the sample area. A resistance heater may be provided. At least one Peltier element may be provided for heating and/or cooling. A heating means may be configured to heat at least a part of the sample to a temperature of more than 500 °C, in particular more than 1000 °C and in one configuration of approximately 1500 °C and/or less than 2000 °C. In-situ processes under defined temperature conditions, in particular at elevated temperatures, can thus be studied.

Powering the heater, the cooler and/or another component means providing electrical energy to the respective component in order to operate the respective component as intended.

Typically, sample holders for heating and/or cooling are commercially available. Such sample holders have at least two electrical contacts to which the electrical connection for the heating and/or cooling means can be established.

In one embodiment, the device comprises at least one biasing electrode, wherein the contact section has at least one further electrical contact for establishing an electrical connection with the sample holder to power the biasing electrode. The device may comprise two biasing electrodes.

The presence of a biasing electrode allows for performing biasing experiments. Thus, electrochemical and electronic experiments can be performed in-situ, enabling studies such as, for example, photoelectrocatalysis and solar cells. Insights in the fundamental mechanisms as well as optimization of materials are thus possible to increase efficiency of the studied devices.

Typically, sample holders that allow for biasing are commercially available. Such sample holders have two electrical contacts to which the electrical connection for the biasing electrode can be established.

In one embodiment, the device comprises at least one spacer, in particular two spacers, to form a channel and/or to maintain a gap between an upper part and a lower part. Thus, a fluid flow channel can easily be manufactured and provided. This allows to perform experiments with a gaseous environment and/or different pressures.

In one configuration, the device comprises a clamping means to clamp together the upper part and the lower part so that the sample area is closed, and in particular sealed by the sealing member. In an additional or alternative configuration, the sample holder acts as a clamping means and clamps together the upper part and the lower part when holding the device. These solutions can be combined.

In one embodiment, the light source is configured such that light having different wavelengths can be emitted to illuminate the sample. Therefore, photoexcitation processes with different wavelengths can be studied in-situ. For example, a combination of different LEDs and/or LED materials and/or dopings may be used.

A further aspect of the invention is a system comprising a device according to the invention and a sample holder. The sample holder is configured to hold the device using the holding section of the device. The sample holder has at least two electrical contacts for establishing the electrical connection to the contact section of the device. In one embodiment, the system further comprises an optical appliance, in particular an electron microscope.

A further aspect of the invention is a method for manufacturing a device for holding a sample for use with an optical appliance such as an electron microscope. The method is in particular for manufacturing a device according to the invention. The method comprises providing a sample area for arranging a sample, growing, as a light source, a light-emitting diode, and arranging the light source such that a sample arranged in the sample area can be illuminated by the light source. In particular, the method comprises providing a substrate or wafer. In particular, the light source is grown on the substrate or wafer. All features, embodiments and effects of the device described at the beginning also apply to the manufacturing method and vice versa.

A further aspect of the invention is a method for holding a sample in an optical appliance such as an electron microscope, in particular using a device according to the invention. The method comprises illuminating a sample arranged in a sample area with light in such a way that the light radiates from a place of formation to the sample on an essentially linear path. All features, embodiments and effects of the device described at the beginning also apply to the method for holding and vice versa.

The sample is directly illuminated. In particular, light from the light source radiates from the light source or the place where it is formed (produced) to the sample on an essentially linear path. The light is therefore not deflected, such as by a light guide, optical fiber or mirror. It is possible that a light emitted from the light source hits the sample in different angles and/or forms a beam angle. However, each light wave radiates along an essentially linear path. The light path may have small deviations from the linear shape due to interaction with objects, the atmosphere or other radiation.

In particular, the sample is held in an optical appliance such as an electron microscope. In particular, an interaction of a sample with light is visualized using the optical appliance. In particular, the light source directly illuminates the sample. In particular, the method comprises inserting the device in a sample holder and/or inserting the device together with a sample holder into the optical appliance.

A fluid environment may be provided. A height of a fluid layer may be larger than 1 nm, in particular 10 nm and/or smaller than 1000 nm, in particular 500 nm. A gas environment may be provided. In particular, photon luminescence is provided to the sample. In particular, a photon induced reaction process is performed. In particular, a variable photon flux is applied to the sample. In particular, a variation of the photon flux is performed during the experiment and/or in a continuous manner. The optical appliance may be used to create a visual image during the experiment and/or while illuminating the sample.

A further aspect of the invention is the use of a device according to the invention or a device manufactured according to the invention for studying and/or visualizing interaction of a sample with light using an optical appliance, in particular an electron microscope. All features, embodiments and effects of the device described at the beginning also apply to the use and vice versa.

In the following, exemplary embodiments of the invention are also explained in more detail with reference to figures. Features of the exemplary embodiments may be combined individually or in a plurality with the claimed subject matter, unless otherwise indicated. The claimed areas of protection are not limited to the exemplary embodiments.

The figures show:
- Figure 1:: a schematic perspective view of a device according to the invention;
- Figure 2:: a schematic perspective view of parts of a device; and
- Figure 3:: another schematic perspective view of parts of a device.

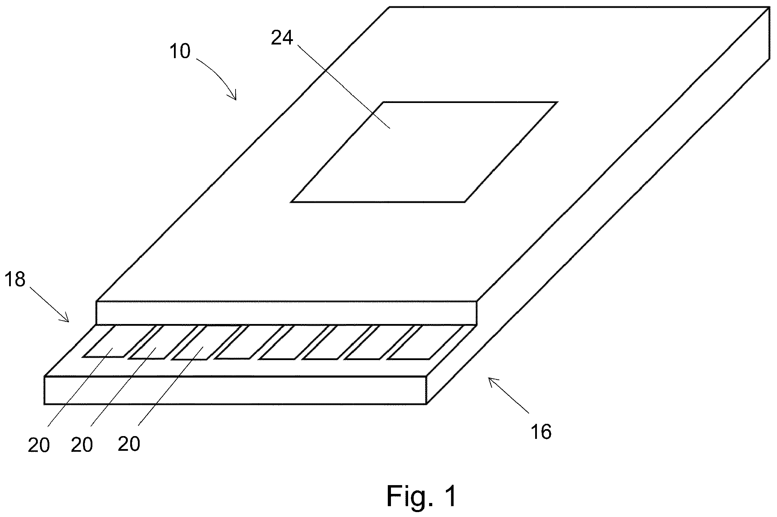

Figure 1 shows a device 10 for holding a sample according to the invention. The device 10 shown may be manufactured in one piece or in two pieces, for example an upper part and a lower part as shown in the following figures. The device 10 has a width of approximately 3 mm.

A sample area 12 (which is not shown in figure 1) is arranged inside the device 10. A light source 14 is arranged within the device 10 in order to illuminate the sample arranged in the sample area. An electron-transparent window 24 is arranged in at least an upper wall of the device 10 so that electrons can get into the sample area to reach the sample and/or get out of the sample area from the sample. Thus, the electron transparent window 24 extends through the upper wall of the device 10 into the sample area 12. This allows to study the sample when it is illuminated by the light source using an optical device such as an electron microscope. The electron-transparent window 24 may be configured as a thin membrane. An opening may be provided as an alternative to the electron-transparent window 24 in a basic configuration of the invention.

The device 10 further comprises a holding section 16 which can be held by a sample holder of the optical appliance. The holding section 16 may comprise the left and right outer walls of the device 10 at or close to the end shown in the front. Additionally or alternatively, the holding section 16 may comprise the upper and lower walls in said region. In particular, the holding section 16 is configured for being clamped by clamping means of the sample holder.

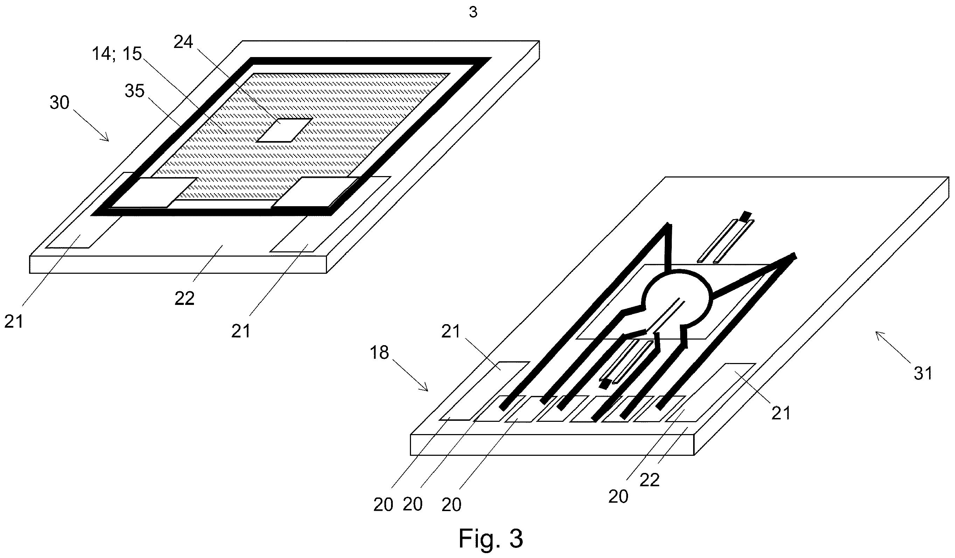

The device 10 comprises a step at the end shown in the front. A lower part of the device is longer than an upper part of the device and extends beyond the upper part at the front. The upper part and the lower part may be separate or integral. At the upper surface of the lower part, eight electrical contacts 20 are arranged. Two of these electrical contacts 20 serve for establishing an electrical connection with the sample holder in order to power the light source, as shown in Fig. 3 and explained in more detail below.

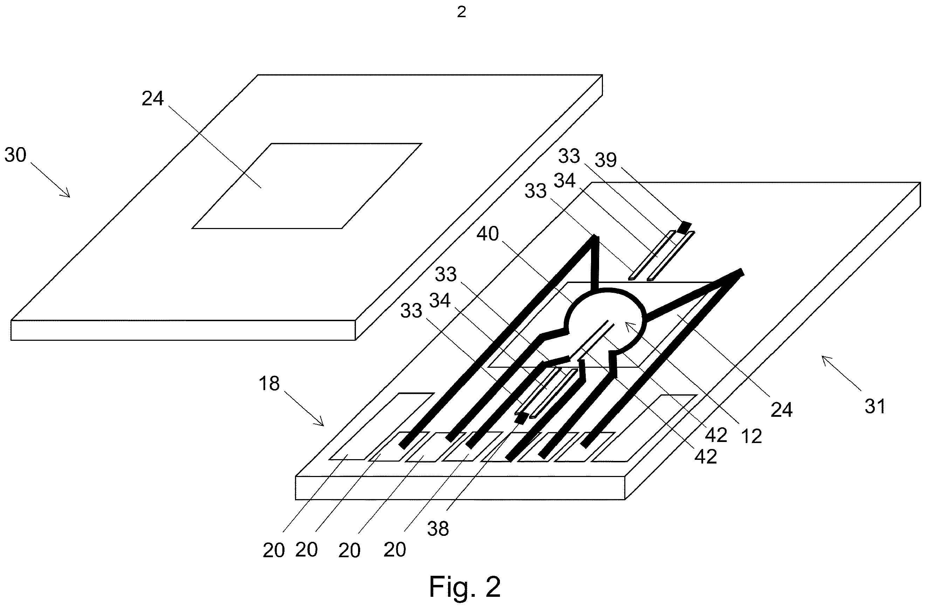

Figure 2 shows a device 10 according to the invention, in particular the device 10 of figure 1, in a disassembled state. The device 10 shown consists of an upper part 30 and a lower part 31 which are individual parts. Starting from the assembled state, the upper part 30 has been lifted upwards and moved to the left to reach the position shown in Figure 3.

The sample area 12 is shown approximately centrally on the lower part 31. During operation, the sample is thus enclosed by the lower part 31 and the upper part 30. The device 10 shown in figure 2 comprises two electron-transparent windows 24 which overlap in such a manner that the sample area 12 is located between them. This allows to perform electron transmission spectroscopy.

In the contact section 18, the device 10 comprises eight electrical contacts 20. Each electrical contact 20 is configured as a contact pad. The two outer electrical contacts 20 are larger than the six inner electrical contacts 20. The two outer electrical contacts 20 serve for powering the light source which is explained in more detail with reference to figure 3 below.

The central two electrical contacts 20 are connected to biasing electrodes 42 which are arranged close to the center of the sample area 12. The four electrical contacts 20 positioned between the central two electrical contacts 20 and the two outer electrical contacts 20 are connected to a heating and/or cooling means 40. The heating and/or cooling means 40 shown which uses four electrical contacts 20 allows for very precise heating and for heating to very high temperatures up to 1500 °C. Alternatively, a heating and/or cooling means 40 with only two electrical contacts 20 could be used. The presence of a cooling and/or heating means 40 and a biasing electrode 42 is purely optional and a corresponding number of electrical contacts 20 has to be provided for each specific case.

The device may comprise a fluid inlet 38 and a fluid outlet 39 through which a fluid can enter and exit the device 10. Note that the reference numerals 38 and 39 are only shown by way of example and that also the opening on the upper right may be the fluid inlet 38 and the opening on the lower left may be the fluid outlet 39. As the device 10 allows for multiple photoelectrochemical reactions in a micro-scale, it is considered a microelectromechanical system or a nanoreactor.

The device 10 comprises on its lower part 31 to pairs of spacers 33. Between each pair of spacers 33, a fluid channel 34 is formed through which fluid can flow which enters and exits the device 10. Through the fluid channel is 34, the fluid is led from the fluid inlet 38 to the sample area 12 and from the sample area 12 to the fluid outlet 39. The spacers 33 may also define the distance of the upper part 30 and the lower part 31.

The holding section 16 (cf. Fig. 1) may be part of the upper part 30 and/or the lower part 31.

Figure 3 shows a further device 10 according to the invention, in particular the device 10 of figure 2. In contrast to figure 2, the upper part 30 has been turned around so that its underside faces upwards and is thus visible. Features which have already been described with respect to figures 1 and 2 are not repeated here for the sake of conciseness. Reference is made to the respective figures and the above description.

The upper part 30 comprises on its underside, which is visible in figure 3, contact points 21 configured as contact pads. The contact points 21 have approximately an L-shape. The contact points 21 are arranged such that they at least partially overlap with the outer two electrical contacts 20 of the lower part 31 in the assembled state. Said outer two electrical contacts 20 are also configured as contact points 21. During operation, they perform a double function. First, the other two electrical contacts 20 are electrically contacted by corresponding electrical contacts of the sample holder. Second, they electrically contact the contact points 21 of the upper part 30.

Sealing member 35 is configured as an O-ring which is arranged circumferentially around the sample area 12 in the assembled state. The upper part 30 and/or the lower part 31 may comprise an O-ring groove in which the O-ring is inserted. Parts of the contact points 21 located outside the O-ring are electrically connected with parts of the contact points 21 located inside the O-ring. Typically, the contact points 21 or contact pads continuously extend below the O-ring.

As a light source 14, an LED 15 is arranged approximately centrally on the underside of the upper part 30 and/or within the O-ring. In the areas within the O-ring, the contact points 21 contact different regions of the LED 15 so that light can be emitted when the device 10 is held by a sample holder of an optical appliance and the electrical connections are established as described.

In the assembled state, the O-ring encloses the sample area 12 such that a desired gas and/or liquid environment and/or a desired pressure can be established in the sample area 12 and/or around the sample.

In particular, the LED 15 has an opening which may be a central opening. An electron-transparent window 24 may be visible through the opening and/or arranged in the opening so that insights into the sample area 12 are possible with the optical appliance.

In the assembled state, the LED 15 can illuminate the whole sample area 12 and, thus, a sample arranged there. Therefore, light emission is very effective and efficient. The upper part 30 is manufactured from a wafer 22 and the LED 15 has been grown on the wafer 22. Typically, also the lower part 31 is manufactured from a wafer 22. The LED 15 may be configured to emit light having different wavelengths. For this purpose, the LED may comprise a combination of different light emitting diodes.

The LED 15 may occupy at least 10% and/or at most 50% of the surface area of the upper part 30. The opening or the electron-transparent window 24 may occupy at least 5% and/or at most 20% of the surface area of the upper part 30. The groove for the sealing member 35 may occupy at least 5% and/or at most 10% of the surface area of the upper part 30. The electrical contact points 21 may occupy at least 5% and/or at most 10% of the surface area of the upper part 30. A remaining surface area of the upper part 30 may be unoccupied. The thickness of the electron-transparent window 24 on the upper part 30 may be at least 30 nm and/or at most 100 nm. The thickness of the remaining wafer of the upper part 30 may be at least 300 nm and/or at most 500 nm.

The opening or the electron-transparent window 24 may occupy at least 20% and/or at most 50% of the surface area of the lower part 31. The sample area 12 may occupy at least 10% and/or at most 50% of the surface area of the electron-transparent window 24 or of the lower part 31. The thickness of the electron-transparent window 24 on the lower part 31 may be at least 30 nm and/or at most 100 nm. The thickness of the remaining wafer of the lower part 31 may be at least 300 nm and/or at most 500 nm.

The heating and/or cooling means 40 may occupy at least 5% and/or at most 10% of the surface area of the lower part 31. The biasing electrode 42 may occupy at least 2% and/or at most 5% of the surface area of the lower part 31. The fluid inlet 38 and the fluid outlet 39 may occupy at least 2% and/or at most 5% of the surface area of the lower part 31. The electrical contact points 21 may occupy at least 5% and/or at most 10% of the surface area of the lower part 31. The spacers 32 and/or the fluid channel 34 may occupy at least 2% and/or at most 10% of the surface area of the lower part 31. The spacer 32 and/or the flow channel before may have an height of at least 1 µm and/or at most 10 µm. A remaining surface area of the upper part 30 may be unoccupied.

**List of reference signs**

| | |
|---|---|
| device | 10 |
| sample area | 12 |
| light source | 14 |
| light-emitting diode | 15 |
| holding section | 16 |
| contact section | 18 |
| electrical contact | 20 |
| contact point | 21 |
| wafer | 22 |
| electron-transparent window | 24 |
| upper part | 30 |
| lower part | 31 |
| spacer | 33 |
| fluid channel | 34 |
| sealing member | 35 |
| groove | 36 |
| fluid inlet | 38 |
| fluid outlet | 39 |
| heating and/or cooling means | 40 |
| biasing electrode | 42 |

## Claims

1. A device (10) for holding a sample for use with an optical appliance, in particular an electron microscope, the device (10) comprising:
- a sample area (12) for arranging a sample,
- a light source (14) for illuminating the sample arranged in the sample area (12),
- a holding section (16) which enables the device (10) to be held by a sample holder of the optical appliance, and
- a contact section (18) having at least two electrical contacts (20) for establishing an electrical connection with the sample holder to power the light source (14).

2. The device (10) according to claim 1, **characterized in that** the device (10) is a microelectromechanical system.

3. The device (10) according to one of the preceding claims, **characterized in that** the device (10) is manufactured at least partly from a wafer (22), wherein the light source (14) is a light-emitting diode (15) which has been grown on the wafer (22).

4. The device (10) according to one of the preceding claims, **characterized in that** the device (10) comprises an electron-transparent window (24) to allow electrons to get into the device (10) to the sample and/or get out of the device (10) from the sample.

5. The device (10) according to one of the preceding claims, **characterized in that** the device (10) comprises two separate parts (30, 31), namely an upper part (30) and a lower part (31), wherein the light source (14) is part of the upper part (30) and the sample area (12) is arranged on the lower part (31) or is at least partly limited by the lower part (31).

6. The device (10) according to the preceding claim, **characterized in that** a sealing member (35) is arranged between the upper part (30) and the lower part (31) to seal the sample area (12) towards the environment.

7. The device (10) according to one of the preceding claims, **characterized in that** the device (10) comprises a fluid inlet (38) which allows a fluid to enter the sample area (12) and a fluid outlet (39) which allows the fluid to be removed from the sample area (12).

8. The device (10) according to one of the preceding claims, **characterized in that** the device (10) comprises a heating and/or cooling means (40), wherein the contact section (18) has at least two further electrical contacts (20) for establishing an electrical connection with the sample holder to power the heating and/or cooling means (40).

9. The device (10) according to one of the preceding claims, **characterized in that** the device (10) comprises at least one biasing electrode (42), wherein the contact section (18) has at least one further electrical contact (20) for establishing an electrical connection with the sample holder to power the biasing electrode (42).

10. The device (10) according to one of the preceding claims, **characterized in that** the device (10) comprises at least one spacer (33), in particular two spacers (33), to form a fluid channel (34) and/or to maintain a gap between an upper part (30) and a lower part (31) of the device (10).

11. The device (10) according to one of the preceding claims, **characterized in that** the light source (14) is configured such that light having different wavelengths can be emitted to illuminate the sample.

12. System comprising a device (10) according to one of the claims 1 to 11 and a sample holder, wherein the sample holder is configured to hold the device (10) using the holding section (16) of the device (10), wherein the sample holder has at least two electrical contacts (20) for establishing the electrical connection to the contact section (18) of the device (10).

13. System according to the preceding claim, **characterized in that** the system further comprises an optical appliance, in particular an electron microscope.

14. Method for manufacturing a device (10) for holding a sample for use with an optical appliance such as an electron microscope, in particular for manufacturing a device (10) according to one of the claims 1 to 11, the method comprising:
- providing a sample area (12) for arranging a sample,
- growing, as a light source (14), a light-emitting diode (15), and
- arranging the light source (14) such that a sample arranged in the sample area (12) can be illuminated by the light source (14).

15. Method for holding a sample in an optical appliance such as an electron microscope, in particular using a device (10) according to one of the claims 1 to 11, wherein the method comprises illuminating a sample arranged in a sample area (12) with light in such a way that the light radiates from a place of formation to the sample on an essentially linear path.
